# EUROPEAN PATENT SPECIFICATION

(11) **EP 4 068 368 B1**
(45) Date of publication and mention of the grant of the patent: **09.09.2026**
(21) Application number: 20892685.7
(22) Date of filing: 10.02.2020
(51) Int. Cl.: H10H 29/01, H10H 29/80, H10H 29/49

(54) **DISPLAY DEVICE USING SEMICONDUCTOR LIGHT EMITTING ELEMENTS, AND METHOD FOR MANUFACTURING SAME**
ANZEIGEVORRICHTUNG MIT LICHTEMITTIERENDEN HALBLEITERBAUELEMENTEN UND VERFAHREN ZUR HERSTELLUNG DAVON
DISPOSITIF D'AFFICHAGE UTILISANT DES ÉLÉMENTS ÉLECTROLUMINESCENTS À SEMI-CONDUCTEUR, ET SON PROCÉDÉ DE FABRICATION

(30) Priority: 28.11.2019 KR 20190156081
(43) Date of publication of application: 05.10.2022
(73) Proprietor: LG Electronics Inc., SEOUL 07336 (KR)
(72) Inventor: CHOI, Hwanjoon, Seoul 06772 (KR)
(74) Representative: Vossius & Partner Patentanwälte Rechtsanwälte mbB
(86) International application number: PCT/KR2020/001812
(87) International publication number: WO 2021/107270

(56) References cited:
- EP-A1- 3 182 470
- JP-A- 2004 039 983
- KR-A- 20180 055 549
- KR-A- 20180 114 439
- KR-A- 20190 052 112
- KR-A- 20190 057 681
- KR-A- 20190 092 331
- US-A1- 2011 254 029
- US-B1- 6 693 352

## Description

### Technical Field

The present disclosure relates to a display device and a method of manufacturing the same, and more particularly, to a display device using a semiconductor light emitting element having a size of several µm to several tens of µm and a method of manufacturing the same.

### Background Art

In recent years, display devices having excellent characteristics such as low profile, flexibility and the like have been developed in the display technical field. On the contrary, currently commercialized main displays are represented by liquid crystal displays (LCDs) and active matrix organic light emitting diodes (AMOLEDs).

On the other hand, light emitting diodes (LEDs) are well known semiconductor light emitting elements for converting an electrical current to light, and have been used as a light source for displaying an image in an electronic device including information communication devices since red LEDs using GaAsP compound semiconductors were made commercially available in 1962, together with a GaP:N-based green LEDs. Accordingly, the semiconductor light emitting elements may be used to implement a flexible display, thereby presenting a scheme for solving the problems.

The semiconductor light emitting element is transferred onto a substrate in various ways. As one of methods of transferring semiconductor light emitting elements, a transfer method using an anisotropic conductive layer is used. The use of an anisotropic conductive layer has an advantage capable of electrically connecting a semiconductor light emitting element and a wiring electrode only by thermal compression, but there is a problem that a contact failure between the semiconductor light emitting element and the wiring electrode occurs when an area of a wiring substrate is increased.
US 2011/254029 (A1) relates to a method for manufacturing an LED module incorporating a plurality of LEDs.
EP 3 182 470 (A1) relates to a flexible display device using a semiconductor light emitting device.
KR 2018 0114439 (A) relates to a display device using a semiconductor light emitting device.

### Disclosure of Invention

### Technical Problem

An aspect of the present disclosure is to provide a structure for preventing the occurrence of contact failure between a semiconductor light emitting element and a wiring electrode when the semiconductor light emitting element is compressed to the wiring electrode using an anisotropic conductive layer, and a manufacturing method thereof.

In addition, another aspect of the present disclosure is to provide a structure and a manufacturing method for preventing the semiconductor light emitting element from being damaged due to a non-uniform pressure applied to a substrate when the semiconductor light emitting element is pressed to the wiring electrode using an anisotropic conductive layer.

### Solution to Problem

In order to achieve the foregoing objectives, the present disclosure provides a display device as defined in claim 1 and a method claim as defined in claim 6. Preferred embodiments are defined by the dependent claims.

### Advantageous Effects of Invention

In a display device according to the present disclosure, when a semiconductor light emitting element is pressed onto a wiring substrate, the flow of an isotropic conductive layer may be minimized, thereby preventing conductive particles from being released between the semiconductor light emitting element and a wiring electrode. Through this, the present disclosure may prevent a contact failure between the semiconductor light emitting element and the wiring electrode.

In addition, according to the present disclosure, when the semiconductor light emitting element is pressed onto the wiring substrate, a protruding portion disposed on the conductive electrode may serve as a pressing margin, thereby preventing the semiconductor light emitting element from being damaged even when a pressure is unevenly applied during a pressing process.

### Brief Description of Drawings

FIG. 1 is a conceptual view showing a display device using a semiconductor light emitting element according to an embodiment of the present disclosure.
FIG. 2 is a partial enlarged view of portion A in FIG. 1, and FIGS. 3A and 3B are cross-sectional views taken along lines B-B and C-C in FIG. 2.
FIG. 4 is a conceptual view showing a flip-chip type semiconductor light emitting element in FIG. 3.
FIGS. 5A to 5C are conceptual views showing various forms for implementing colors in connection with a flip-chip type semiconductor light emitting element.
FIG. 6 is cross-sectional views showing a method of manufacturing a display device using a semiconductor light emitting element of the present disclosure.
FIG. 7 is a perspective view showing a display device using a semiconductor light emitting element according to another embodiment of the present disclosure.
FIG. 8 is a cross-sectional view taken along line D-D in FIG. 7.
FIG. 9 is a conceptual view showing a vertical semiconductor light emitting element in FIG. 8.
FIGS. 10 and 11 are conceptual views showing a problem occurring during pressing described in FIG. 6.
FIG. 12 is a conceptual view showing a method of manufacturing a display device according to the present disclosure.
FIGS. 13 and 14 are photographs of a surface of a conductive electrode manufactured based on a method of manufacturing a display device according to the present disclosure.
FIGS. 15 and 16 are conceptual views showing a method of manufacturing a display device according to the present disclosure.
FIGS. 17 to 19 are conceptual views showing a method of forming an anisotropic conductive layer, and then transferring a semiconductor light emitting element.
FIG. 20 is a cross-sectional view showing a cross section of a display device according to the present disclosure.

### Mode for the Invention

Hereinafter, the embodiments disclosed herein will be described in detail with reference to the accompanying drawings, and the same or similar elements are designated with the same numeral references regardless of the numerals in the drawings and their redundant description will be omitted. A suffix "module" and "unit" used for constituent elements disclosed in the following description is merely intended for easy description of the specification, and the suffix itself does not give any special meaning or function. In describing an embodiment disclosed herein, moreover, the detailed description will be omitted when specific description for publicly known technologies to which the invention pertains is judged to obscure the gist of the present disclosure. Also, it should be noted that the accompanying drawings are merely illustrated to easily explain the concept of the invention, and therefore, they should not be construed to limit the technological concept disclosed herein by the accompanying drawings.

Furthermore, it will be understood that when an element such as a layer, region or substrate is referred to as being "on" another element, it can be directly on the another element or an intermediate element may also be interposed therebetween.

A display device disclosed herein may include a portable phone, a smart phone, a laptop computer, a digital broadcast terminal, a personal digital assistant (PDA), a portable multimedia player (PMP), a navigation, a slate PC, a tablet PC, an ultrabook, a digital TV, a desktop computer, and the like. However, it would be easily understood by those skilled in the art that a configuration disclosed herein may be applicable to any displayable device even though it is a new product type which will be developed later.

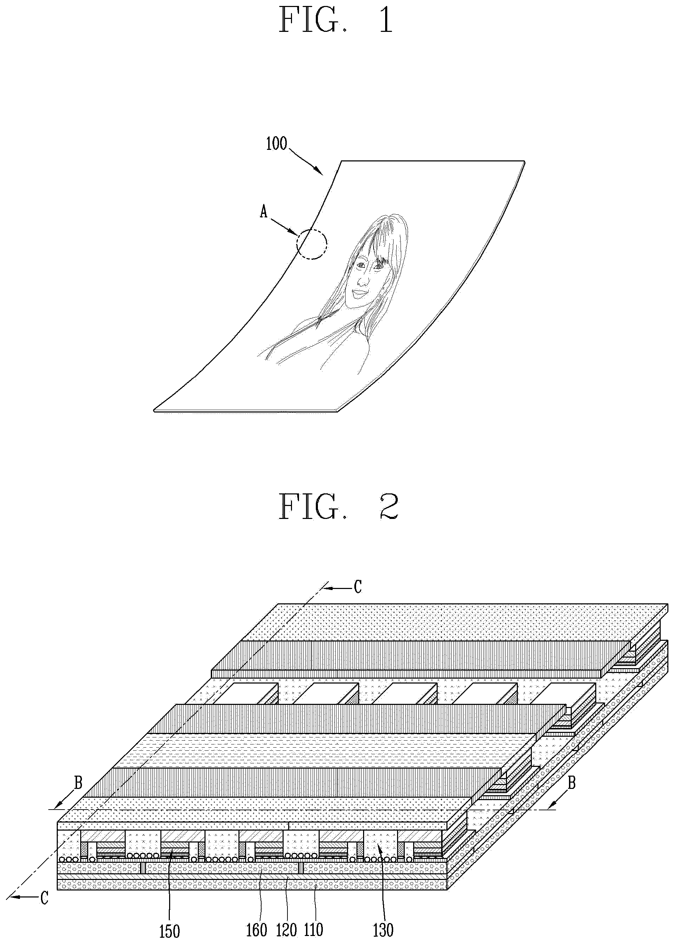

FIG. 1 is a conceptual view showing a display device using a semiconductor light emitting element according to an embodiment of the present disclosure.

According to the drawing, information processed in the controller of the display device 100 may be displayed using a flexible display.

The flexible display may include a flexible, bendable, twistable, foldable and rollable display. For example, the flexible display may be a display manufactured on a thin and flexible substrate that can be warped, bent, folded or rolled like a paper sheet while maintaining the display characteristics of a flat display in the related art.

A display area of the flexible display becomes a plane in a configuration that the flexible display is not warped (for example, a configuration having an infinite radius of curvature, hereinafter, referred to as a "first configuration"). The display area thereof becomes a curved surface in a configuration that the flexible display is warped by an external force in the first configuration (for example, a configuration having a finite radius of curvature, hereinafter, referred to as a "second configuration"). As illustrated, information displayed in the second configuration may be visual information displayed on a curved surface. The visual information may be realized in such a manner that a light emission of each unit pixel (sub-pixel) arranged in a matrix configuration is controlled independently. The sub-pixel denotes a minimum unit for implementing one color.

The sub-pixel of the flexible display may be implemented by a semiconductor light emitting element. According to the present disclosure, a light emitting diode (LED) is illustrated as a type of semiconductor light emitting element. The light emitting diode may be formed with a small size to perform the role of a sub-pixel even in the second configuration through this.

Hereinafter, a flexible display implemented using the light emitting diode will be described in more detail with reference to the accompanying drawings.

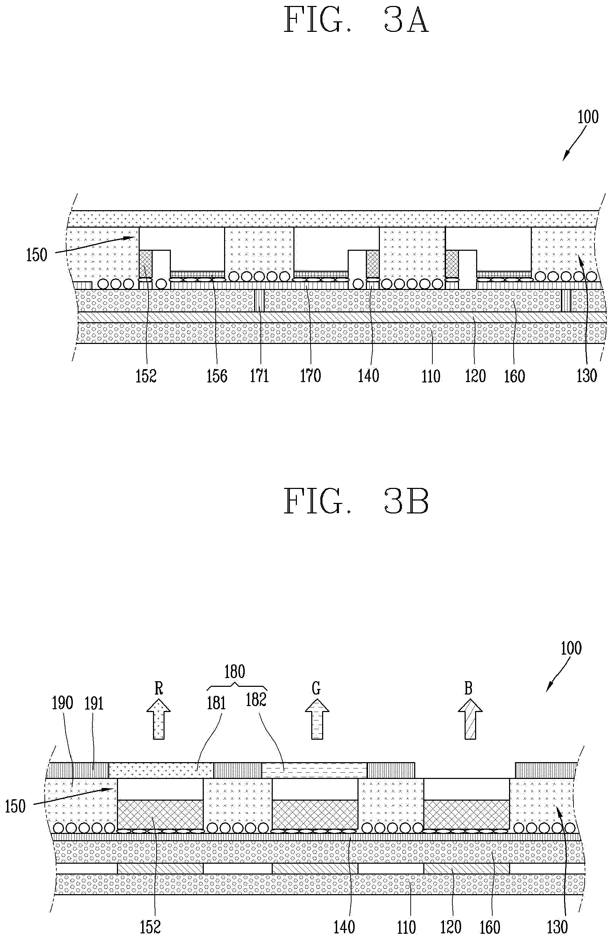

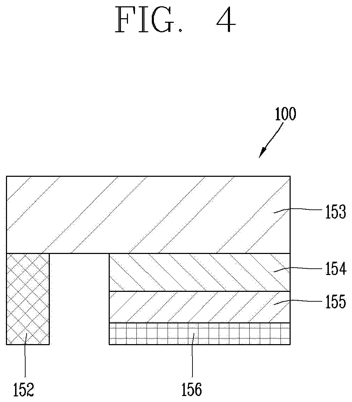

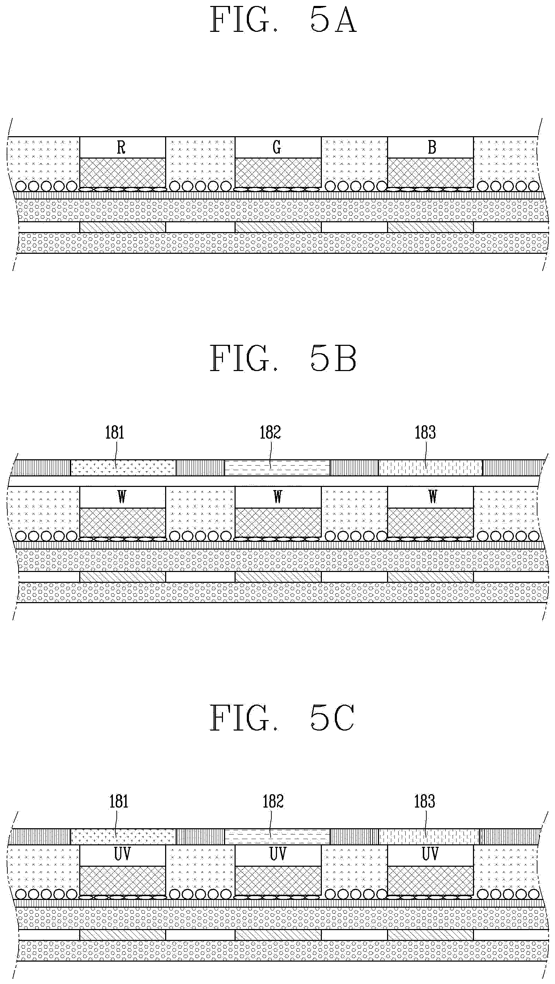

FIG. 2 is a partial enlarged view of portion A in FIG. 1, FIGS. 3A and 3B are cross-sectional views taken along lines B-B and C-C in FIG. 2, FIG. 4 is a conceptual view showing a flip-chip type semiconductor light emitting element in FIG. 3A, and FIGS. 5A to 5C are conceptual views showing various forms for implementing colors in connection with a flip-chip type semiconductor light emitting element.

According to the drawings in FIGS. 2, 3A and 3B, there is illustrated a display device 100 using a passive matrix (PM) type semiconductor light emitting element as a display device 100 using a semiconductor light emitting element. However, an example described below may also be applicable to an active matrix (AM) type semiconductor light emitting element.

The display device 100 may include a substrate 110, a first electrode 120, a conductive adhesive layer 130, a second electrode 140, and a plurality of semiconductor light emitting elements 150.

The substrate 110 may be a flexible substrate. The substrate 110 may contain glass or polyimide (PI) to implement the flexible display device. In addition, if it is an insulating and flexible material, any one such as polyethylene naphthalate (PEN), polyethylene terephthalate (PET) or the like may be used. Furthermore, the substrate 110 may be either one of transparent and non-transparent materials.

The substrate 110 may be a wiring substrate disposed with the first electrode 120, and thus the first electrode 120 may be placed on the substrate 110.

According to the drawing, an insulating layer 160 may be disposed on the substrate 110 placed with the first electrode 120, and an auxiliary electrode 170 may be placed on the insulating layer 160. In this case, a configuration in which the insulating layer 160 is deposited on the substrate 110 may be single wiring substrate. More specifically, the insulating layer 160 may be incorporated into the substrate 110 with an insulating and flexible material such as polyimide (PI), PET, PEN or the like to form single wiring substrate.

The auxiliary electrode 170 as an electrode for electrically connecting the first electrode 120 to the semiconductor light emitting element 150 is placed on the insulating layer 160, and disposed to correspond to the location of the first electrode 120. For example, the auxiliary electrode 170 has a dot shape, and may be electrically connected to the first electrode 120 by means of an electrode hole 171 passing through the insulating layer 160. The electrode hole 171 may be formed by filling a conductive material in a via hole.

Referring to the drawings, the conductive adhesive layer 130 may be formed on one surface of the insulating layer 160, but the present disclosure may not be necessarily limited to this. For example, it may be possible to also have a structure in which the conductive adhesive layer 130 is disposed on the substrate 110 with no insulating layer 160. The conductive adhesive layer 130 may perform the role of an insulating layer in the structure in which the conductive adhesive layer 130 is disposed on the substrate 110.

The conductive adhesive layer 130 may be a layer having adhesiveness and conductivity, and to this end, a conductive material and an adhesive material may be mixed on the conductive adhesive layer 130. Furthermore, the conductive adhesive layer 130 may have flexibility, thereby allowing a flexible function in the display device. The conductive adhesive layer 130 is an anisotropic conductive film (ACF), an anisotropic conductive paste, a solution containing conductive particles, and the like. The conductive adhesive layer 130 may allow electrical interconnection in the z-direction passing through the thickness thereof, but may be configured as a layer having electrical insulation in the horizontal x-y direction thereof. Accordingly, the conductive adhesive layer 130 may be referred to as a z-axis conductive layer (however, hereinafter referred to as a "conductive adhesive layer").

The anisotropic conductive film is a film with a form in which an anisotropic conductive medium is mixed with an insulating base member, and thus when heat and pressure are applied thereto, only a specific portion thereof may have conductivity by means of the anisotropic conductive medium. Hereinafter, heat and pressure are applied to the anisotropic conductive film, but other methods may be also available for the anisotropic conductive film to partially have conductivity. The methods may include applying only either one of heat and pressure thereto, UV curing, and the like.

Furthermore, the anisotropic conductive medium is made of conductive balls or particles. According to the drawing, in this example, the anisotropic conductive film is a film with a form in which an anisotropic conductive medium is mixed with an insulating base member, and thus when heat and pressure are applied thereto, only a specific portion thereof may have conductivity by means of the conductive balls. The anisotropic conductive film may be in a state in which a core with a conductive material contains a plurality of particles coated by an insulating layer with a polymer material, and in this case, it may have conductivity by means of the core while breaking an insulating layer on a portion to which heat and pressure are applied. Here, a core may be transformed to implement a layer having both surfaces to which objects contact in the thickness direction of the film. For a more specific example, heat and pressure are applied to an anisotropic conductive film as a whole, and electrical connection in the z-axis direction is partially formed by a height difference from a mating object adhered by the use of the anisotropic conductive film.

For another example, an anisotropic conductive film may be in a state containing a plurality of particles in which a conductive material is coated on insulating cores. In this case, a portion to which heat and pressure are applied may be converted (pressed and adhered) to a conductive material to have conductivity in the thickness direction of the film. For still another example, it may be formed to have conductivity in the thickness direction of the film in which a conductive material passes through an insulating base member in the z-direction. In this case, the conductive material may have a pointed end portion.

According to the drawing, the anisotropic conductive film may be a fixed array anisotropic conductive film (ACF) configured with a form in which conductive balls are inserted into one surface of the insulating base member. More specifically, the insulating base member is formed of an adhesive material, and the conductive balls are intensively disposed at a bottom portion of the insulating base member, and when heat and pressure are applied thereto, the base member is modified along with the conductive balls, thereby having conductivity in the vertical direction thereof.

However, the present disclosure may not be necessarily limited to this, and the anisotropic conductive film may be all allowed to have a form in which conductive balls are randomly mixed with an insulating base member or a form configured with a plurality of layers in which conductive balls are disposed at any one layer (double-ACF), and the like.

The anisotropic conductive paste as a form coupled to a paste and conductive balls may be a paste in which conductive balls are mixed with an insulating and adhesive base material. Furthermore, a solution containing conductive particles may be a solution in a form containing conductive particles or nano particles.

Referring again to the drawing, the second electrode 140 is located at the insulating layer 160 to be separated from the auxiliary electrode 170. In other words, the conductive adhesive layer 130 is disposed on the insulating layer 160 located with the auxiliary electrode 170 and second electrode 140.

When the conductive adhesive layer 130 is formed while the auxiliary electrode 170 and second electrode 140 are located, and then the semiconductor light emitting element 150 is connect thereto in a flip-chip form with the application of heat and pressure, the semiconductor light emitting element 150 is electrically connected to the first electrode 120 and second electrode 140.

Referring to FIG. 4, the semiconductor light emitting element may be a flip-chip type semiconductor light emitting element.

For example, the semiconductor light emitting element may include a p-type electrode 156, a p-type semiconductor layer 155 formed with the p-type electrode 156, an active layer 154 formed on the p-type semiconductor layer 155, an n-type semiconductor layer 153 formed on the active layer 154, and an n-type electrode 152 disposed to be separated from the p-type electrode 156 in the horizontal direction on the n-type semiconductor layer 153. In this case, the p-type electrode 156 may be electrically connected to the welding portion 179 by the conductive adhesive layer 130, and the n-type electrode 152 may be electrically connected to the second electrode 140.

Referring again to FIGS. 2, 3A and 3B, the auxiliary electrode 170 may be formed in an elongated manner in one direction to be electrically connected to a plurality of semiconductor light emitting elements 150. For example, the left and right p-type electrodes of the semiconductor light emitting elements around the auxiliary electrode may be electrically connected to one auxiliary electrode.

More specifically, the semiconductor light emitting element 150 is pressed into the conductive adhesive layer 130, and through this, only a portion between the p-type electrode 156 and auxiliary electrode 170 of the semiconductor light emitting element 150 and a portion between the n-type electrode 152 and second electrode 140 of the semiconductor light emitting element 150 have conductivity, and the remaining portion does not have conductivity since there is no push-down of the semiconductor light emitting element. As described above, the conductive adhesive layer 130 may form an electrical connection as well as allow a mutual coupling between the semiconductor light emitting element 150 and the auxiliary electrode 170 and between the semiconductor light emitting element 150 and the second electrode 140.

Furthermore, a plurality of semiconductor light emitting elements 150 constitute a light emitting array, and a phosphor layer 180 is formed on the light emitting array.

The light emitting element array may include a plurality of semiconductor light emitting elements with different self-luminance values. Each of the semiconductor light emitting elements 150 constitutes a sub-pixel, and is electrically connected to the first electrode 120. For example, there may exist a plurality of first electrodes 120, and the semiconductor light emitting elements are arranged in several rows, for instance, and each row of the semiconductor light emitting elements may be electrically connected to any one of the plurality of first electrodes.

Furthermore, the semiconductor light emitting elements may be connected in a flip-chip form, and thus semiconductor light emitting elements grown on a transparent dielectric substrate. Furthermore, the semiconductor light emitting elements may be nitride semiconductor light emitting elements, for instance. Since the semiconductor light emitting element 150 has excellent luminance, an individual sub-pixel may be defined even with a small size.

According to the drawing, a partition wall 190 may be formed between the semiconductor light emitting elements 150. In this case, the partition wall 190 may perform the role of dividing individual sub-pixels from one another, and be formed as an integral body with the conductive adhesive layer 130. For example, a base member of the anisotropic conductive film may form the partition wall when the semiconductor light emitting element 150 is inserted into the anisotropic conductive film.

Furthermore, when the base member of the anisotropic conductive film is black, the partition wall 190 may have reflective characteristics while at the same time increasing contrast with no additional black insulator.

For another example, a reflective partition wall may be separately provided with the partition wall 190. In this case, the partition wall 190 may include a black or white insulator according to the purpose of the display device. When a partition wall of a white insulator is used, an effect of enhancing reflectivity may be obtained. When a partition wall of a black insulator is used, a contrast ratio may be increased while having a reflection characteristic.

The phosphor layer 180 may be located at an outer surface of the semiconductor light emitting element 150. For example, the semiconductor light emitting element 150 is a blue semiconductor light emitting element that emits blue (B) light, and the phosphor layer 180 performs a function of converting the blue (B) light into the color of a sub-pixel. The phosphor layer 180 may be a red phosphor layer 181 or green phosphor layer 182 constituting individual pixels.

In other words, a red phosphor 181 capable of converting blue light into red (R) light may be deposited on the blue semiconductor light emitting element 151 at a position implementing a red sub-pixel, and a green phosphor 182 capable of converting blue light into green (G) light may be deposited on the blue semiconductor light emitting element 151 at a position implementing a green sub-pixel. Furthermore, only the blue semiconductor light emitting element 151 may be solely used at a location implementing a blue sub-pixel. In this case, the red (R), green (G) and blue (B) sub-pixels may implement one pixel. More specifically, one color phosphor may be deposited along each line of the first electrode 120. Accordingly, one line on the first electrode 120 may be an electrode controlling one color. In other words, red (R), green (B) and blue (B) may be sequentially disposed along the second electrode 140, thereby implementing sub-pixels.

However, the present disclosure may not be necessarily limited to this, and the semiconductor light emitting element 150 may be combined with a quantum dot (QD) instead of a phosphor to implement sub-pixels such as red (R), green (G) and blue (B).

Furthermore, a black matrix 191 may be disposed between each phosphor layer to enhance contrast. In other words, the black matrix 191 can enhance the contrast of luminance.

However, the present disclosure may not be necessarily limited to this, and another structure for implementing blue, red and green may be also applicable thereto.

Referring to FIG. 5A, each of the semiconductor light emitting elements 150 may be implemented with a high-power light emitting element that emits various lights including blue in which gallium nitride (GaN) is mostly used, and indium (In) and or aluminum (Al) are added thereto.

In this case, the semiconductor light emitting element 150 may be red, green and blue semiconductor light emitting elements, respectively, to implement each sub-pixel. For instance, red, green and blue semiconductor light emitting elements (R, G, B) are alternately disposed, and red, green and blue sub-pixels implement one pixel by means of the red, green and blue semiconductor light emitting elements, thereby implementing a full color display.

Referring to FIG. 5B, the semiconductor light emitting element may have a white light emitting element (W) provided with a yellow phosphor layer for each element. In this case, a red phosphor layer 181, a green phosphor layer 182 and blue phosphor layer 183 may be provided on the white light emitting element (W) to implement a sub-pixel. Furthermore, a color filter repeated with red, green and blue on the white light emitting element (W) may be used to implement a sub-pixel.

Referring to FIG. 5C, it may be possible to also have a structure in which a red phosphor layer 181, a green phosphor layer 182 and blue phosphor layer 183 may be provided on a ultra violet light emitting element (UV). In this manner, the semiconductor light emitting element can be used over the entire region up to ultra violet (UV) as well as visible light, and may be extended to a form of semiconductor light emitting element in which ultra violet (UV) can be used as an excitation source.

Taking the present example into consideration again, the semiconductor light emitting element 150 is placed on the conductive adhesive layer 130 to configure a sub-pixel in the display device. The semiconductor light emitting element 150 may have excellent luminance characteristics, and thus it may be possible to configure individual sub-pixels even with a small size thereof. A size of an individual semiconductor light emitting element 150 may have a side length of 80 µm or less, and may be a rectangular or square device. In case of a rectangular shaped element, the size thereof may be less than 20 x 80 µm.

Furthermore, even when a square shaped semiconductor light emitting element 150 with a length of side of 10 µm is used for a sub-pixel, it will exhibit a sufficient brightness for implementing a display device. Accordingly, for example, in case of a rectangular pixel in which one side of a sub-pixel is 600 µm in size, and the remaining one side thereof is 300 µm, a relative distance between the semiconductor light emitting elements becomes sufficiently large. Accordingly, in this case, it may be possible to implement a flexible display device having a HD image quality.

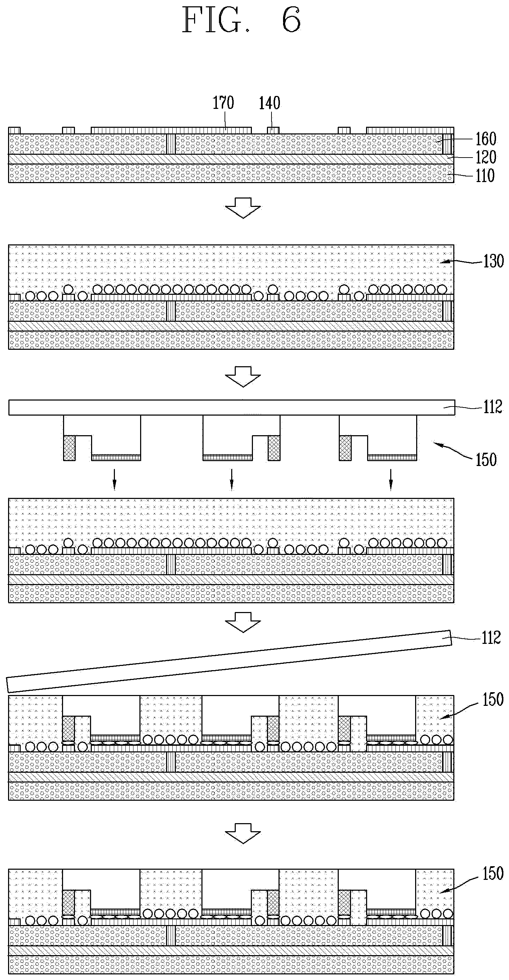

A display device using the foregoing semiconductor light emitting element will be manufactured by a new type of manufacturing method. Hereinafter, the manufacturing method will be described with reference to FIG. 6.

FIG. 6 is cross-sectional views showing a method of manufacturing a display device using a semiconductor light emitting element of the present disclosure.

Referring to the drawing, first, the conductive adhesive layer 130 is formed on the insulating layer 160 located with the auxiliary electrode 170 and second electrode 140. The insulating layer 160 is deposited on the first substrate 110 to form one substrate (or wiring substrate), and the first electrode 120, auxiliary electrode 170 and second electrode 140 are disposed at the wiring substrate. In this case, the first electrode 120 and second electrode 140 may be disposed in a perpendicular direction to each other. Furthermore, the first substrate 110 and insulating layer 160 may contain glass or polyimide (PI), respectively, to implement a flexible display device.

The conductive adhesive layer 130 is implemented by an anisotropic conductive film, for example, and to this end, an anisotropic conductive film may be coated on a substrate located with the insulating layer 160.

Next, a second substrate 112 located with a plurality of semiconductor light emitting elements 150 corresponding to the location of the auxiliary electrodes 170 and second electrodes 140 and constituting individual pixels is disposed such that the semiconductor light emitting element 150 faces the auxiliary electrode 170 and second electrode 140.

In this case, the second substrate 112 as a growth substrate for growing the semiconductor light emitting element 150 may be a sapphire substrate or silicon substrate.

The semiconductor light emitting element may have a gap and size capable of implementing a display device when formed in the unit of wafer, and thus effectively used for a display device.

Next, the wiring substrate is thermally compressed to the second substrate 112. For example, the wiring substrate and second substrate 112 may be thermally compressed to each other by applying an ACF press head. The wiring substrate and second substrate 112 are bonded to each other using the thermal compression. Only a portion between the semiconductor light emitting element 150 and the auxiliary electrode 170 and second electrode 140 may have conductivity due to the characteristics of an anisotropic conductive film having conductivity by thermal compression, thereby allowing the electrodes and semiconductor light emitting element 150 to be electrically connected to each other. At this time, the semiconductor light emitting element 150 may be inserted into the anisotropic conductive film, thereby forming a partition wall between the semiconductor light emitting elements 150.

Next, the second substrate 112 is removed. For example, the second substrate 112 may be removed using a laser lift-off (LLO) or chemical lift-off (CLO) method.

Finally, the second substrate 112 is removed to expose the semiconductor light emitting elements 150 to the outside. Silicon oxide (SiOₓ) or the like may be coated on the wiring substrate coupled to the semiconductor light emitting element 150 to form a transparent insulating layer (not shown).

Furthermore, the method may further include placing a phosphor layer on one surface of the semiconductor light emitting element 150. For example, the semiconductor light emitting element 150 may be a blue semiconductor light emitting element for emitting blue (B) light, and red or green phosphor for converting the blue (B) light into the color of the sub-pixel may form a layer on one surface of the blue semiconductor light emitting element.

The manufacturing method or structure of a display device using the foregoing semiconductor light emitting element may be modified in various forms. For such an example, the foregoing display device may be applicable to a vertical semiconductor light emitting element. Hereinafter, the vertical structure will be described with reference to FIGS. 5 and 6.

Furthermore, according to the following modified example or embodiment, the same or similar reference numerals are designated to the same or similar configurations to the foregoing example, and the description thereof will be substituted by the earlier description.

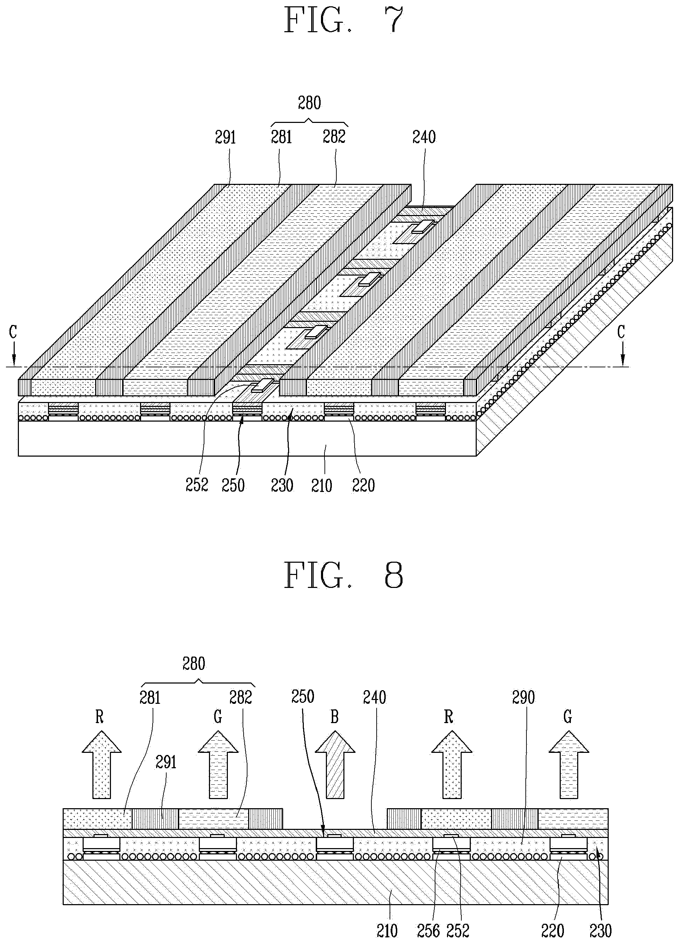

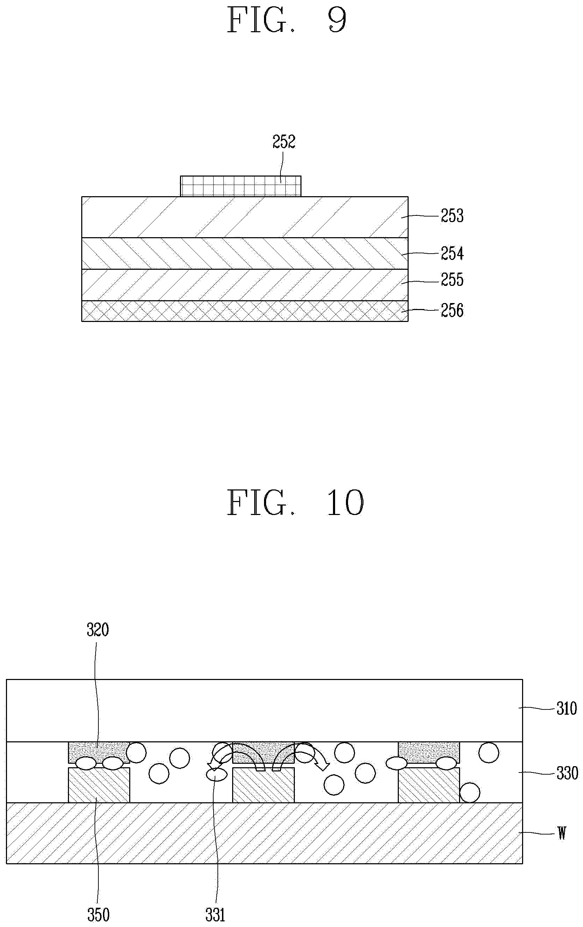

FIG. 7 is a perspective view showing a display device using a semiconductor light emitting element according to another embodiment of the present disclosure, FIG. 8 is a cross-sectional view taken along line C-C in FIG. 7, and FIG. 9 is a conceptual view showing a vertical type semiconductor light emitting element in FIG. 8.

According to the drawings, the display device may be display device using a passive matrix (PM) type of vertical semiconductor light emitting element.

The display device may include a substrate 210, a first electrode 220, a conductive adhesive layer 230, a second electrode 240 and a plurality of semiconductor light emitting elements 250.

The substrate 210 as a wiring substrate disposed with the first electrode 220 may include polyimide (PI) to implement a flexible display device. In addition, any one may be used if it is an insulating and flexible material.

The first electrode 220 may be located on the substrate 210, and formed with a bar-shaped electrode elongated in one direction. The first electrode 220 may be formed to perform the role of a data electrode.

The conductive adhesive layer 230 is formed on the substrate 210 located with the first electrode 220. Similarly to a display device to which a flip-chip type light emitting element is applied, the conductive adhesive layer 230 is an anisotropic conductive film (ACF), an anisotropic conductive paste, a solution containing conductive particles, and the like. However, the present embodiment illustrates a case where the conductive adhesive layer 230 is implemented by an anisotropic conductive film.

When an anisotropic conductive film is located in a state that the first electrode 220 is located on the substrate 210, and then heat and pressure are applied to connect the semiconductor light emitting element 250 thereto, the semiconductor light emitting element 250 is electrically connected to the first electrode 220. At this time, the semiconductor light emitting element 250 may be preferably disposed on the first electrode 220.

The electrical connection is generated because an anisotropic conductive film partially has conductivity in the thickness direction when heat and pressure are applied as described above. Accordingly, the anisotropic conductive film is partitioned into a portion having conductivity and a portion having no conductivity in the thickness direction thereof.

Furthermore, the anisotropic conductive film contains an adhesive component, and thus the conductive adhesive layer 230 implements a mechanical coupling as well as an electrical coupling between the semiconductor light emitting element 250 and the first electrode 220.

As such, the semiconductor light emitting element 250 is positioned on the conductive adhesive layer 230, thereby constituting an individual pixel in the display device. Since the semiconductor light emitting element 250 has excellent luminance, an individual sub-pixel may be defined even with a small size. The size of the individual semiconductor light emitting element 250 may be less than 80 µm in the length of one side thereof, and formed with a rectangular or square shaped element. In case of a rectangular shaped element, the size thereof may be less than 20 x 80 µm.

The semiconductor light emitting element 250 may be a vertical structure.

A plurality of second electrodes 240 disposed in a direction of crossing the length direction of the first electrode 220, and electrically connected to the vertical semiconductor light emitting element 250 may be located between vertical semiconductor light emitting elements.

Referring to FIG. 9, the vertical semiconductor light emitting element may include a p-type electrode 256, a p-type semiconductor layer 255 formed with the p-type electrode 256, an active layer 254 formed on the p-type semiconductor layer 255, an n-type semiconductor layer 253 formed on the active layer 254, and an n-type electrode 252 formed on the n-type semiconductor layer 253. In this case, the p-type electrode 256 located at the bottom thereof may be electrically connected to the first electrode 220 by the conductive adhesive layer 230, and the n-type electrode 252 located at the top thereof may be electrically connected to the second electrode 240 which will be described later. The electrodes may be disposed in the upward/downward direction in the vertical semiconductor light emitting element 250, thereby providing a great advantage capable of reducing the chip size.

Referring again to FIG. 8, a phosphor layer 280 may be formed on one surface of the semiconductor light emitting element 250. For example, the semiconductor light emitting element 250 is a blue semiconductor light emitting element 251 that emits blue (B) light, and the phosphor layer 280 for converting the blue (B) light into the color of the sub-pixel may be provided thereon. In this case, the phosphor layer 280 may be a red phosphor 281 and a green phosphor 282 constituting individual pixels.

In other words, a red phosphor 281 capable of converting blue light into red (R) light may be deposited on the blue semiconductor light emitting element 251 at a position implementing a red sub-pixel, and a green phosphor 282 capable of converting blue light into green (G) light may be deposited on the blue semiconductor light emitting element 251 at a position implementing a green sub-pixel. Furthermore, only the blue semiconductor light emitting element 251 may be solely used at a location implementing a blue sub-pixel. In this case, the red (R), green (G) and blue (B) sub-pixels may implement one pixel.

However, the present disclosure may not be necessarily limited to this, and another structure for implementing blue, red and green may be also applicable thereto as described above in a display device to which a flip-chip type light emitting element is applied.

Taking the present embodiment into consideration again, the second electrode 240 is located between the semiconductor light emitting elements 250, and electrically connected to the semiconductor light emitting elements 250. For example, the semiconductor light emitting elements 250 may be disposed in a plurality of rows, and the second electrode 240 may be located between the rows of the semiconductor light emitting elements 250.

Since a distance between the semiconductor light emitting elements 250 constituting individual pixels is sufficiently large, the second electrode 240 may be located between the semiconductor light emitting elements 250.

The second electrode 240 may be formed with a bar-shaped electrode elongated in one direction, and disposed in a perpendicular direction to the first electrode.

Furthermore, the second electrode 240 may be electrically connected to the semiconductor light emitting element 250 by a connecting electrode protruded from the second electrode 240. More specifically, the connecting electrode may be an n-type electrode of the semiconductor light emitting element 250. For example, the n-type electrode is formed with an ohmic electrode for ohmic contact, and the second electrode covers at least part of the ohmic electrode by printing or deposition. Through this, the second electrode 240 may be electrically connected to the n-type electrode of the semiconductor light emitting element 250.

According to the drawing, the second electrode 240 may be located on the conductive adhesive layer 230. According to circumstances, a transparent insulating layer (not shown) containing silicon oxide (SiOₓ) may be formed on the substrate 210 formed with the semiconductor light emitting element 250. When the transparent insulating layer is formed and then the second electrode 240 is placed thereon, the second electrode 240 may be located on the transparent insulating layer. Furthermore, the second electrode 240 may be formed to be separated from the conductive adhesive layer 230 or transparent insulating layer.

When a transparent electrode such as indium tin oxide (ITO) is used to locate the second electrode 240 on the semiconductor light emitting element 250, the ITO material has a problem of bad adhesiveness with an n-type semiconductor. Accordingly, the second electrode 240 may be placed between the semiconductor light emitting elements 250, thereby obtaining an advantage in which the transparent electrode is not required. Accordingly, an n-type semiconductor layer and a conductive material having a good adhesiveness may be used as a horizontal electrode without being restricted by the selection of a transparent material, thereby enhancing the light extraction efficiency.

According to the drawing, a partition wall 290 may be formed between the semiconductor light emitting elements 250. In other words, the partition wall 290 may be disposed between the vertical semiconductor light emitting elements 250 to isolate the semiconductor light emitting element 250 constituting individual pixels. In this case, the partition wall 290 may perform the role of dividing individual sub-pixels from one another, and be formed as an integral body with the conductive adhesive layer 230. For example, a base member of the anisotropic conductive film may form the partition wall when the semiconductor light emitting element 250 is inserted into the anisotropic conductive film.

Furthermore, when the base member of the anisotropic conductive film is black, the partition wall 290 may have reflective characteristics while at the same time increasing contrast with no additional black insulator.

For another example, a reflective partition wall may be separately provided with the partition wall 290. The partition wall 290 may include a black or white insulator according to the purpose of the display device.

When the second electrode 240 is precisely located on the conductive adhesive layer 230 between the semiconductor light emitting elements 250, the partition wall 290 may be located between the vertical semiconductor light emitting element 250 and second electrode 240. Accordingly, individual sub-pixels may be configured even with a small size using the semiconductor light emitting element 250, and a distance between the semiconductor light emitting elements 250 may be relatively sufficiently large to place the second electrode 240 between the semiconductor light emitting elements 250, thereby having the effect of implementing a flexible display device having a HD image quality.

Furthermore, according to the drawing, a black matrix 291 may be disposed between each phosphor layer to enhance contrast. In other words, the black matrix 291 can enhance the contrast of luminance.

As described above, the semiconductor light emitting element 250 is positioned on the conductive adhesive layer 230, thereby constituting an individual pixel in the display device. Since the semiconductor light emitting element 250 has excellent luminance, an individual sub-pixel may be defined even with a small size. As a result, it may be possible to implement a full color display in which the sub-pixels of red (R), green (G) and blue (B) implement one pixel by means of the semiconductor light emitting element.

An anisotropic conductive film (ACF) is used in a display device described above. The anisotropic conductive film (hereinafter, anisotropic conductive layer) is made of a mixture of conductive balls (hereinafter, conductive particles) and an insulating material. As described with reference to FIG. 6, when a substrate on which the semiconductor light emitting element is formed is thermally compressed to a wiring substrate coated with an anisotropic conductive layer, the wiring electrode and the semiconductor light emitting element are electrically connected by conductive particles.

During thermal compression, the conductive particles are compressed between the semiconductor light emitting element and the wiring electrode to electrically connect the semiconductor light emitting element and the wiring electrode. In order for the semiconductor light emitting element and the wiring electrode to be electrically connected, pressure above a predetermine level must be applied to conductive particles.

Referring to FIG. 10, during thermal compression, a contact failure between the semiconductor light emitting element 350 and the wiring electrode 320 may occur due to the fluidity of an anisotropic conductive layer 330. Specifically, during thermal compression, conductive particles 331 must be located between the semiconductor light emitting element 350 and the wiring electrode 320, but due to external pressure, the conductive particles 331 may move without staying in between the semiconductor light emitting element 350 and the wiring electrode. In this case, the semiconductor light emitting element 350 and the wiring electrode 320 are incompletely electrically connected.

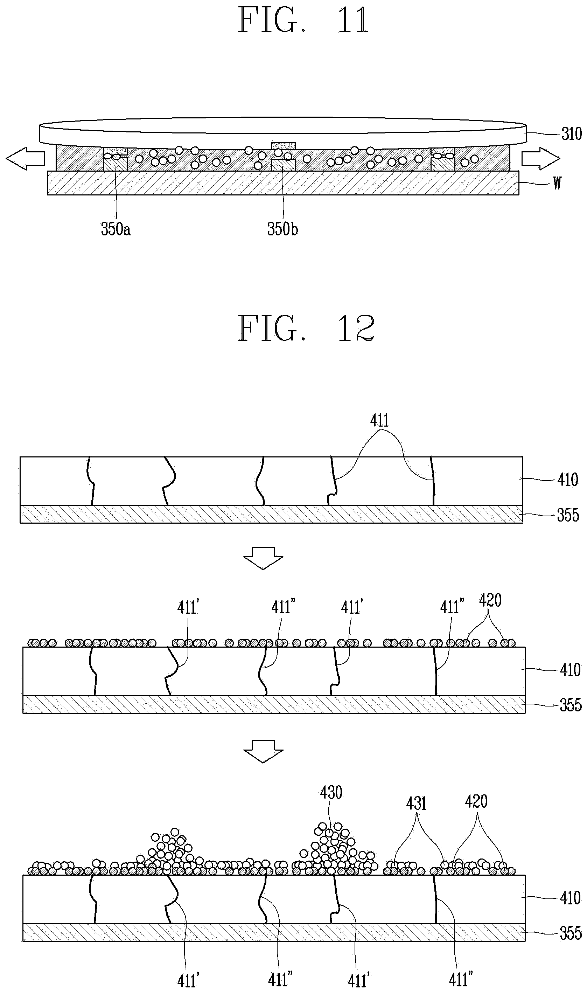

On the other hand, referring to FIG. 11, as an area of the wiring substrate 310 increases, pressure applied to each region of the wiring substrate 110 during thermal compression becomes non-uniform. Specifically, when the area of the wiring substrate is large, relatively high pressure is applied to an edge region of the wiring substrate, and a relatively low pressure is applied to a central region of the wiring substrate. Due to this, the conductive particles are completely pressed to the wiring electrode and the semiconductor light emitting element in the edge region of the wiring substrate, but sufficient pressure is not applied to the conductive particles in the central region of the wiring substrate, thereby resulting in poor contact between the wiring electrode and the semiconductor light emitting element.

For the above reasons, when the wiring substrate and the transfer substrate are strongly pressed to each other, the semiconductor light emitting element disposed in an edge region of the wiring substrate may be damaged. To prevent this, a pressing margin between the wiring substrate and the transfer substrate is required.

The present disclosure provides a structure of preventing conductive particles from being released between the semiconductor light emitting element and the wiring electrode, and applying a uniform pressure to an entire wiring substrate during the foregoing thermal compression, and a manufacturing method thereof.

In addition, the present disclosure provides a structure and a manufacturing method capable of securing a bonding margin between the wiring substrate and the transfer substrate during the foregoing thermal compression.

First, a method of manufacturing a display device according to the present disclosure will be described.

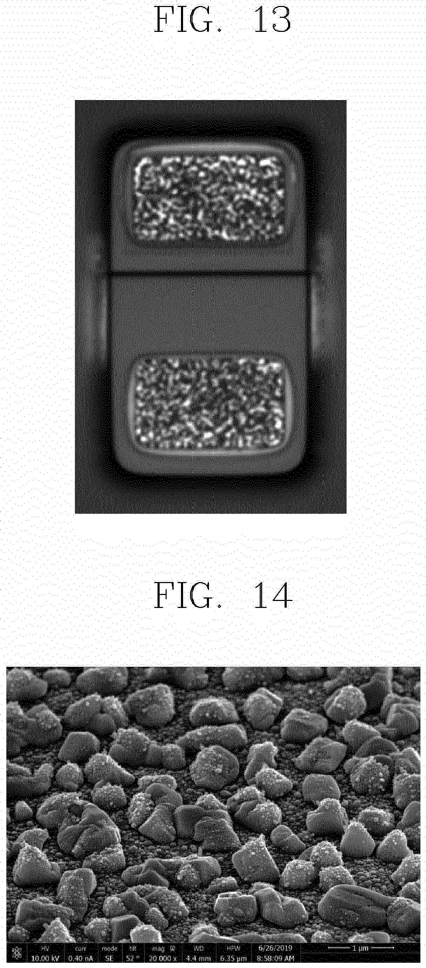

FIG. 12 is a conceptual view showing a method of manufacturing a display device according to the present disclosure, and FIGS. 13 and 14 are photographs of a surface of a conductive electrode manufactured based on a method of manufacturing a display device according to the present disclosure.

First, a step of forming a conductive electrode on a surface of each of a plurality of semiconductor light emitting elements disposed on a transfer substrate is carried out.

The transfer substrate (W) may be a wafer on which the semiconductor light emitting element 350 is disposed, or a substrate onto which the semiconductor light emitting element 350 has been transferred at least once from the wafer. According to the present invention, a conductive electrode is disposed on a surface of a semiconductor light emitting element on a wafer, or a conductive electrode is disposed on a substrate to which the semiconductor light emitting element has been transferred at least once.

In the manufacturing method according to the present invention, the deposition of the conductive electrode is performed by depositing three types of different metals or alloys.

Hereinafter, the forming of the conductive electrode will be described in detail.

First, a step of forming a first metal layer 410 on a surface of the semiconductor light emitting element is carried out. Here, the surface of the semiconductor light emitting element refers to a surface of the conductive semiconductor layer 153 or 155 included in the semiconductor light emitting element described with reference to FIGS. 1 to 9. The conductive semiconductor layer on which a first metal layer is formed through the step may be at least one of a p-type and an n-type semiconductor layer. For example, in the case of a flip-chip type semiconductor light emitting element, a conductive electrode may be formed on each of the p-type semiconductor layer and the n-type semiconductor layer.

The metal or alloy constituting the first metal layer 410 is not specifically limited since it is a metal or alloy used as a conductive electrode of the semiconductor light emitting element in the related art.

The first metal layer 410 may be deposited on a conductive semiconductor layer 355 by E-beam or sputter. However, the deposition method of the first metal layer 410 is not limited thereto.

When the first metal layer 410 is formed through a deposition method, a grain boundary 411 having a size of about 100 nm is formed on a surface of the metal layer. Since the formed grain boundary 411 has a structure in which atoms easily move and exists in a state in which binding energy is lowered, when a metal in an active movement state is additionally deposited on the grain boundary 411, the atoms are gathered to the grain boundary 411. In this case, the additionally deposited metal is gathered to the grain boundary 411 and exists in an aggregated form rather than a flat surface state.

The present disclosure uses this phenomenon to form a protruding portion on a surface of the conductive semiconductor layer. However, in the present disclosure, a metal in a relatively low active movement state is deposited on the first metal layer 410 instead of directly depositing a metal in an active movement state on the first metal layer 410.

Specifically, forming the first metal layer 410, and then forming a second metal layer 420 on the first metal layer 410 is carried out. The second metal layer 420 may be deposited on the first metal layer 410 by E-beam or sputter. However, the deposition method of the second metal layer 420 is not limited thereto.

Here, a metal or alloy constituting the second metal layer 420 is different from a metal or alloy constituting the first metal layer. Specifically, the metal or alloy constituting the second metal layer 420 is preferably a metal in a relatively inactive movement state.

Here, the metal in an inactive movement state denotes that the metal does not diffuse well. As the melting point of a metal or alloy increases, diffusion decreases, and thus the metal or alloy constituting the second metal layer 420 must be a metal having a relatively high melting point compared to a protruding portion to be described later. For example, the metal or alloy constituting the second metal layer 420 is preferably any one of Ti, Cr, and Mo, or an alloy in which at least one of the metals is mixed.

Meanwhile, a thickness of the second metal layer 420 is less than 100 nm. Since the second metal layer 420 is a metal having relatively poor diffusion, it is not aggregated on the grain boundary 411 of the first metal layer 410, and is evenly spread throughout the first metal layer 410. When the second metal layer 420 is formed less than 100 nm, the second metal layer 420 may not completely cover the first metal layer 410 because the thickness of the metal layer is very small. Accordingly, a portion of the first metal layer 410 is not covered by the second metal layer 420 and is exposed to the outside. As a result, a portion 411' of the grain boundary formed on the first metal layer 410 is exposed to the outside, and the remainder 411" is covered by the second metal layer 420.

In this state, forming a protruding portion 430 is carried out. The protruding portion 430 may be deposited by E-beam or sputter. However, the deposition method of the protruding portion 430 is not limited thereto.

Here, a metal or alloy constituting the protruding portion 430 is different from a metal or alloy constituting the first and second metal layers 410 and 420. Specifically, the metal or alloy constituting the protruding portion 430 is a metal in a relatively active movement state.

Here, the active movement state of the metal denotes that the metal diffuses well. As the melting point of the metal or alloy decreases, diffusion increases, and thus the metal or alloy constituting the protruding portion must be a metal having a relatively low melting point compared to the second metal layer 420. For example, the metal or alloy constituting the protruding portion 430 is preferably any one of Au, Cu, Ni, Sn, Bi, Pb, and In, or an alloy in which at least one of the metals is mixed.

When a metal or alloy in an active movement state is deposited on the first metal layer 410 partially covering the second metal layer 420, the additionally deposited metal or alloy is aggregated around the externally exposed grain boundary 411'. Accordingly, the additionally deposited metal or alloy does not form a flat layer, but forms an aggregated form. Accordingly, the protruding portion 430 is formed on the grain boundary 411' or formed on the second metal layer 420 around the grain boundary 411'.

Meanwhile, the protruding portion 430 is not formed on the grain boundary 411" covered with the second metal layer 420, but a flat metal layer 431 is formed thereon. According the foregoing description, an interval at which the protruding portions 430 are formed may be adjusted according to a degree of deposition of the second metal layer 420.

In summary, the conductive electrode includes a first region in which the protruding portion 430 is formed on the grain boundary 411', a second region in which the second metal layer 420 and the metal or alloy 431 constituting and the protruding portion are sequentially deposited on the grain boundary 411", and a third region that is a remaining region excluding the grain boundary.

A first metal layer 410, a second metal layer 420, and a metal or alloy 431 constituting the protruding portion 430 are sequentially deposited in the second and third regions, but the protruding portion 430 is not formed thereon. In particular, in the second region, since the second metal layer 420 covers the grain boundary 411", the metal or alloy 431 constituting the protruding portion 430 is prevented from being aggregated to the grain boundary 411". Accordingly, the second region is formed to have a height lower than that of the protruding portion 430. Here, a height of the second region and a height of the protruding portion 430 are based on a surface 355 of the conductive semiconductor layer on which the conductive electrode is formed.

A surface of the conductive electrode manufactured according to the foregoing manufacturing method is shown in FIGS. 13 and 14. Referring to FIGS. 13 and 14, it can be seen that protruding portions are formed at predetermined intervals on a surface of the conductive electrode.

Then, a display device may be manufactured according to a manufacturing method described with reference to FIG. 6. However, the present disclosure is not limited thereto, and the present disclosure provides a new type of transfer method. Hereinafter, a method of forming a conductive electrode and then transferring a semiconductor light emitting element will be described.

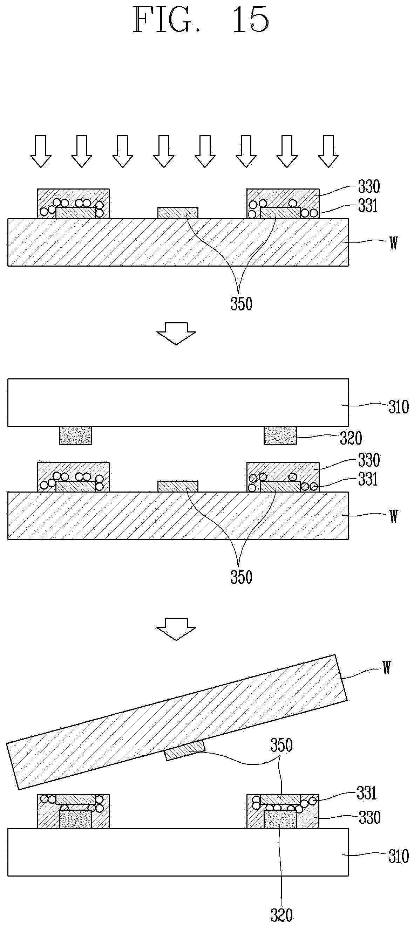

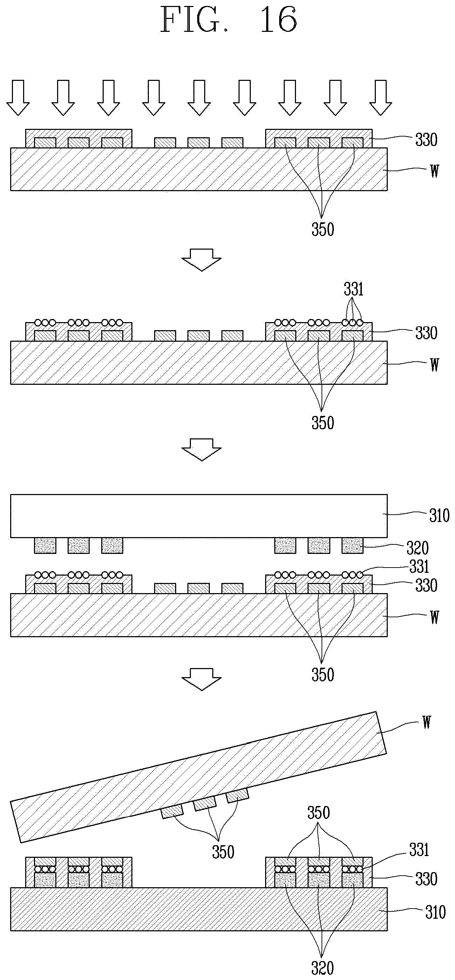

FIGS. 15 and 16 are conceptual views showing a method of manufacturing a display device according to the present disclosure.

First, forming an anisotropic conductive layer on at least some of the plurality of semiconductor light emitting elements 350 disposed on the transfer substrate (W) is carried out.

The transfer substrate (W) may be a wafer on which the semiconductor light emitting element 350 is formed, or a substrate onto which the semiconductor light emitting element 350 is primarily transferred from the wafer. In the present disclosure, an anisotropic conductive layer is formed on the transfer substrate (W). The forming of the anisotropic conductive layer may be carried out in two different ways.

Referring to FIG. 15, the forming of the anisotropic conductive layer may be performed through applying a mixture of a light-transmitting resin and conductive particles on a transfer substrate.

The mixture may be selectively applied only to a region in which the semiconductor light emitting element is formed. To this end, the applying of the mixture may be performed through screen printing.

Meanwhile, the mixture may not be applied to some of the semiconductor light emitting elements 350 disposed on the transfer substrate (W). The anisotropic conductive layer is not disposed on the semiconductor light emitting element to which the mixture is not applied. Accordingly, the semiconductor light emitting element to which the mixture is not applied is not transferred to a substrate on which the wiring electrode, which will be described later, is disposed.

The mixture may be selectively applied only to a position at which the semiconductor light emitting element is disposed. The mixture may be applied to cover a plurality of adjacent semiconductor light emitting elements, or may be applied to cover only one semiconductor light emitting element. Accordingly, a plurality of anisotropic conductive layers may be disposed, and the plurality of anisotropic conductive layers may be spaced apart from each other.

Then, curing the mixture is carried out. The mixture may be cured through photocuring or thermal curing. However, the curing method of the mixture is not limited thereto.

As described above, the anisotropic conductive layer may be formed by applying a light-transmitting resin and conductive particles in a mixed state thereto.

In another embodiment, referring to FIG. 16, the forming of the anisotropic conductive layer may include applying a resin 330 to at least some of the plurality of semiconductor light emitting elements 350 disposed on the transfer substrate (W), and applying the conductive particles 331 on the semiconductor light emitting element to which the resin 330 is applied.

The resin 330 may be selectively applied only to a region in which the semiconductor light emitting element 350 is disposed. To this end, the applying of the resin 330 may be performed through screen printing.

The resin 330 may be applied to cover a plurality of adjacent semiconductor light emitting elements, or may be applied to cover only one semiconductor light emitting element. Accordingly, a plurality of anisotropic conductive layers may be disposed, and the plurality of anisotropic conductive layers may be spaced apart from each other.

Meanwhile, the resin 330 may not be applied to some of the semiconductor light emitting elements 350 disposed on the transfer substrate. The anisotropic conductive layer is not formed on the semiconductor light emitting element to which the resin 300 is not applied. Accordingly, the semiconductor light emitting element to which the resin 330 is not applied is not transferred to a substrate on which the wiring electrode, which will be described later, is disposed.

Then, when the conductive particles 331 are applied, the conductive particles 331 are selectively fixed only to a position at which the resin 330 is formed.

Then, the curing of the resin 330 is carried out. The resin 330 may be cured through photocuring or thermal curing. However, the curing method of the resin 330 is not limited thereto.

As described above, when the method of applying the resin 330 and then applying the conductive particles 331 is used, the conductive particles can be concentrated on a surface of the resin 330. Through this, the present disclosure minimizes the conductive particles from getting out of the designated positions when the wiring substrate and the transfer substrate are pressed to each other.

Referring again to FIGS. 15 and 16, forming an anisotropic conductive layer and then aligning the substrate 310 on which the wiring electrode 320 is formed with the transfer substrate (W), and pressing the substrate 310 to the transfer substrate (W) are carried out.

Since the anisotropic conductive layer 330 according to the present disclosure is formed to have a very small thickness, the anisotropic conductive layer 330 does not significantly flow during a pressing process. In the pressing step, a portion of the anisotropic conductive layer 330 may flow, but since an empty space 360 is mostly formed between the semiconductor light emitting elements 350 and between the wiring electrodes 320, the anisotropic conductive layer 330 flows into the empty space. Through this, the present disclosure allows a pressure to be uniformly applied to an entire region of the substrate 310 during the pressing process.

Meanwhile, in the process of pressing the substrate 310 to the transfer substrate (W), the conductive particles are pressed to a surface of the conductive electrode. At this time, the protruding portion obstructs the movement of the conductive particles to prevent the conductive particles from being released from the designated positions during subsequent transfer.

Meanwhile, the protruding portion may be deformed in shape during the pressing process. Specifically, the protruding portion is pressed in a direction of the semiconductor light emitting element by a pressure applied during the pressing process. As a result, a height of the protruding portion decreases subsequent to the pressing process. In the foregoing manner, the protruding portion serves to secure a pressing margin during the pressing process.

Even when a greater pressure is applied to a central portion of the substrate 310 during the pressing process, the protruding portion may buffer a pressure applied to the semiconductor light emitting element through shape deformation, thereby preventing the semiconductor light emitting element from being damaged.

Meanwhile, in the pressing step, the conductive particles 331 are pressed to electrically connect the semiconductor light emitting element 350 and the wiring electrode 320 to each other. According to the present disclosure, since the flow of the anisotropic conductive layer 330 is minimized, there is a very high possibility in that the conductive particles 331 is released from a position between the semiconductor light emitting element 350 and the wiring electrode 320 in the pressing step.

Meanwhile, the anisotropic conductive layer is not formed on some of the semiconductor light emitting elements 350 disposed on the transfer substrate (W). The semiconductor light emitting element on which the anisotropic conductive layer is not formed is not transferred to the substrate 310. As described above, according to the present disclosure, an anisotropic conductive layer may be selectively formed on only some of the plurality of semiconductor light emitting elements, thereby selectively transferring the some of the semiconductor light emitting elements disposed on the transfer substrate (W).

Meanwhile, the present disclosure provides a method of pressing a semiconductor light emitting element onto a wiring electrode, and then providing a planarization layer while strongly fixing the semiconductor light emitting element onto a wiring substrate.

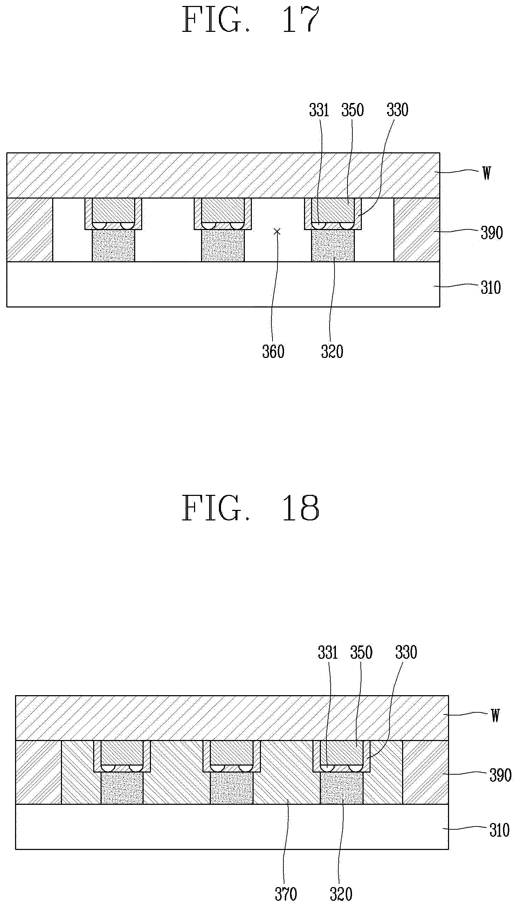

FIGS. 17 to 19 are conceptual views showing a method of forming an anisotropic conductive layer, and then transferring a semiconductor light emitting element.

Referring to the drawings, injecting and then curing a light-transmitting resin into the empty space 360 formed between the transfer substrate (W) and the substrate 310 is carried out.

As a result of the pressing step, the empty space 360 is formed between the transfer substrate (W) and the substrate 310. For planarization, a light-transmitting resin is injected into the empty space 360. The light-transmitting resin 370 supplements the fixing ability of the anisotropic conductive layer 330, which is reduced by decreasing a thickness of the anisotropic conductive layer 330. Specifically, the anisotropic conductive layer 330 having a reduced thickness may not sufficiently fix the semiconductor light emitting element 350 pressed to the wiring electrode. The light-transmitting resin 370 serves to strongly fix the semiconductor light emitting element 350 to the substrate 310 from a side surface of the semiconductor light emitting element 350. Through this, the present disclosure prevents the semiconductor light emitting element from being released from the substrate 310 even when the thickness of the anisotropic conductive layer 330 is reduced.

Meanwhile, a sealing layer 390 may be formed at an edge of the substrate to prevent the resin from leaking out in the step of injecting and then curing the light-transmitting resin 370 into the empty space 360.

The sealing layer 390 is disposed between the substrate 310 and the transfer substrate (W) to prevent the resin from leaking out from the edge of the substrate 310. In the step of injecting and then curing the light-transmitting resin into the empty space 360, the transfer substrate (W) limits a height of the light-transmitting resin layer 370 only to a predetermined level. Accordingly, a height of the semiconductor light emitting element 350 becomes equal to that of the light-transmitting resin layer 370. For this reason, the present disclosure does not require a separate planarization process after transferring the semiconductor light emitting element.

Finally, removing the transfer substrate (W) is carried out. The transfer substrate may be removed by laser lift-off (LLO), but is not limited thereto.

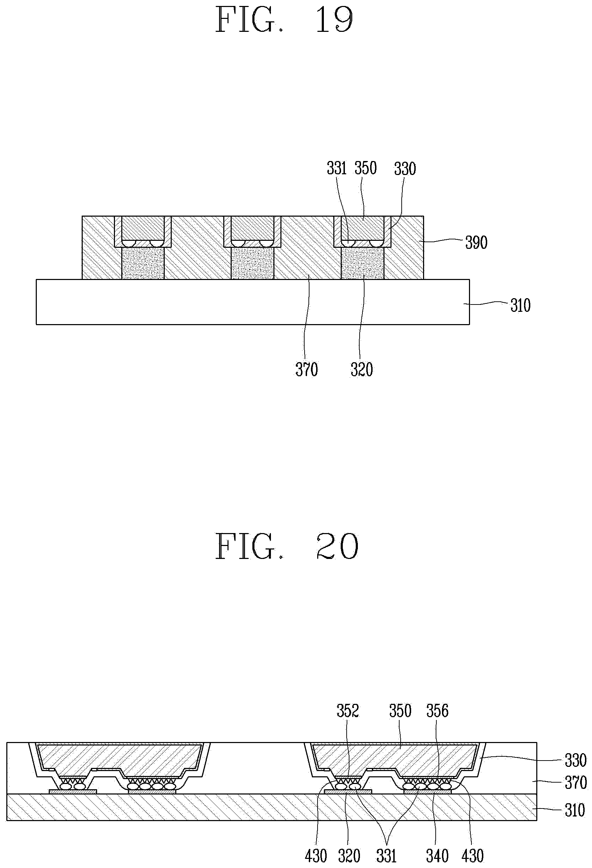

Hereinafter, a display device manufactured by the foregoing method will be described with reference to FIG. 20.

FIG. 20 is a cross-sectional view showing a cross section of a display device according to the present disclosure.

Referring to FIG. 20, the conductive particles 331 positioned between the semiconductor light emitting element 350 and the wiring electrode 320 electrically connect the semiconductor light emitting element 350 and the wiring electrodes 320 and 340 to each other in a pressed state.

Meanwhile, protruding portions 430 protruding toward the wiring electrodes 320 and 340 are formed on the conductive electrodes 352 and 356 provided in each of the semiconductor light emitting elements.

The conductive electrodes 352 and 356 include a first metal layer made of a metal or alloy, a second metal layer made of a metal or alloy different from that of the first metal layer, deposited on the first metal layer, and formed between the first metal layer and the wiring electrode, and the protruding portion protrudes in a direction of the wiring electrode on at least one of the first and second metal layers. Here, the protruding portion 430 is made of a metal or alloy different from those of the first and second metal layers.

Here, a melting point of the metal or alloy constituting the protruding portion 430 is smaller than that of the metal or alloy constituting the second metal layer. Through this, the present disclosure allows the metal or alloy constituting the protruding portion to be aggregated around the grain boundary.

For example, the metal or alloy constituting the protruding portion 430 may be any one of Au, Cu, Ni, Sn, Bi, Pb, and In, or an alloy in which at least one of the above metals is mixed, and the metal or alloy constituting the second metal layer may be any one of Ti, Cr, and Mo, or an alloy in which at least one of the above metals is mixed.

Meanwhile, the protruding portion 430 is formed on a grain boundary formed on the first metal layer. However, the protruding portion 430 is not formed on all grain boundaries formed on the first metal layer. The protruding portion 430 is formed only on a grain boundary that is not covered with the second metal layer.

Accordingly, the conductive electrodes 352 and 356 have three types of regions. Specifically, the conductive electrode includes a first region in which the protruding portion is formed on the grain boundary, a second region in which the second metal layer and the metal or alloy constituting the protruding portion are sequentially deposited on the grain boundary, and a third region that is a remaining region excluding the grain boundary. Here, in the second region, a material such as a metal or an alloy constituting the protruding portion is deposited, but is deposited at a lower height than the protruding portion.

Meanwhile, the light-transmitting layer 370 is formed between the wiring electrodes 320 and between the semiconductor light emitting elements 350. In addition, the light-transmitting layer 370 is formed up to the height of the semiconductor light emitting element 350 to planarize the substrate 310 to which the semiconductor light emitting element 350 is transferred.

The anisotropic conductive layer is formed in a plurality, and any one of the plurality of anisotropic conductive layers spaced apart from each other is formed to surround one semiconductor light emitting element 350 or is formed to surround a plurality of adjacent semiconductor light emitting elements 350.

Meanwhile, the anisotropic conductive layer 330 is formed to surround each side surface of the semiconductor light emitting elements 350. Light emitted from the semiconductor light emitting element 350 passes through the anisotropic conductive layer 330 and is emitted to the outside.

Meanwhile, the conductive particles 331 contained in the anisotropic conductive layer 330 electrically connect both electrodes between the conductive electrodes 352 and 356 and the wiring electrodes 320 and 340.

Meanwhile, since the semiconductor light emitting element is transferred while the anisotropic conductive layer 330 is disposed on the transfer substrate (W), the anisotropic conductive layer is not in contact with the substrate 310 on which the wiring electrodes 320 and 340 are disposed.

In a display device according to the present disclosure, when a semiconductor light emitting element is pressed onto a wiring substrate, the flow of an isotropic conductive layer may be minimized, thereby preventing the conductive particles from being released between the semiconductor light emitting element and a wiring electrode. Through this, the present disclosure may prevent a contact failure between the semiconductor light emitting element and the wiring electrode.

In addition, according to the present disclosure, when the semiconductor light emitting element is pressed onto the wiring substrate, a protruding portion disposed on the conductive electrode may serve as a pressing margin, thereby preventing the semiconductor light emitting element from being damaged even when a pressure is unevenly applied during a pressing process.

The configurations and methods according to the above-described embodiments will not be applicable in a limited way to the foregoing display device using a semiconductor light emitting element, and all or part of each embodiment may be selectively combined and configured to make various modifications thereto, as long as they remain within the scope of the appended claims which define the present invention.

## Claims

1. A display device comprising:
a substrate (110; 210; 310);
a wiring electrode (320) disposed on the substrate (110; 210; 310);
a plurality of semiconductor light emitting elements (150; 250; 350) having a conductive electrode (352, 356) electrically connected to the wiring electrode (320, 340); and
an anisotropic conductive layer (330) disposed between the conductive electrode (352, 356) and the wiring electrode (320, 340), the anisotropic conductive layer (330) being made of a mixture of conductive particles (331) and an insulating material,
wherein the conductive electrode (352, 356) has a protruding portion (430) protruding toward the wiring electrode (320, 340),
wherein the conductive electrode (352, 356) comprises:
a first metal layer (410) made of a metal or an alloy; and
a second metal layer (420) made of a metal or an alloy different from that of the first metal layer (410), deposited on the first metal layer (410), and formed between the first metal layer (410) and the wiring electrode (320, 340),
wherein the second metal layer (420) has a thickness of less than 100nm,
wherein the protruding portion (430) protrudes from at least one of the first and second metal layers (410, 420) in a direction of the wiring electrode (320, 340),
wherein the first metal layer has a grain boundary, and wherein the protruding portion is formed on the grain boundary,
the protruding portion (430) is made of a metal or alloy (431) different from those of the first and second metal layers (410, 420), and a melting point of the metal or alloy (431) constituting the protruding portion (430) is smaller than that of a metal or alloy constituting the second metal layer (420).

2. The display device of claim 1, wherein the metal or alloy (431) constituting the protruding portion (430) is any one of Au, Cu, Ni, Sn, Bi, Pb, or In, or an alloy in which at least one of the metals Au, Cu, Ni, Sn, Bi, Pb, or In is mixed, and
wherein the metal or alloy constituting the second metal layer (420) is any one of Ti, Cr, or Mo, or an alloy in which at least one of the metals Ti, Cr, or Mo is mixed.

3. The display device of claim 1, wherein the conductive electrode (352, 356) comprises:
a first region in which the protruding portion (430) is formed on the grain boundary (411');
a second region in which the metal or alloy constituting the second metal layer (420) and the protruding portion (430) are sequentially deposited on the grain boundary (411"); and
a third region that is a remaining region excluding the grain boundary (411).

4. The display device of claim 3, wherein the second region is formed to have a height lower than that of the protruding portion (430).

5. A method of manufacturing a display device by transferring a plurality of semiconductor light emitting elements (150; 250; 350) to a substrate (110; 210; 310) on which a wiring electrode (320, 340) is formed, the method comprising:
forming a conductive electrode (352, 356) on a surface of each of the plurality of semiconductor light emitting elements (150; 250; 350) disposed on a transfer substrate (W);
forming an anisotropic conductive layer (330) between the conductive electrode (352, 356) and the wiring electrode (320, 340),
wherein the anisotropic conductive layer (330) is made of a mixture of conductive particles (331) and an insulating material,
aligning the substrate (110; 210; 310) on which the wiring electrode (320, 340) is formed with the transfer substrate (W);
pressing the substrate (110; 210; 310) onto the transfer substrate (W); and
removing the transfer substrate (W),
wherein the forming of a conductive electrode (352, 356) on a surface of each of the plurality of semiconductor light emitting elements (150; 250; 350) comprises:
depositing a first metal layer (410) on a surface of the semiconductor light emitting element (150; 250; 350);
depositing a second metal layer (420) on the first metal layer (410) to have a thickness of less than 100 nm; and
depositing a metal or alloy (431) to produce a protruding portion (430) on at least one of the first and second metal layers (410, 420),
wherein
a melting point of a metal or alloy (431) constituting the protruding portion (430) is smaller than that of a metal or alloy constituting the second metal layer (410, 420).

## Patentansprüche

1. Anzeigevorrichtung, umfassend:
ein Substrat (110; 210; 310);
eine auf dem Substrat (110; 210; 310) angeordnete Verdrahtungselektrode (320);
eine Mehrzahl von lichtemittierenden Halbleiterelementen (150; 250; 350), die eine leitfähige Elektrode (352, 356) aufweisen, welche elektrisch mit der Verdrahtungselektrode (320, 340) verbunden ist; und
eine anisotrope leitfähige Schicht (330), die zwischen der leitfähigen Elektrode (352, 356) und der Verdrahtungselektrode (320, 340) angeordnet ist, wobei die anisotrope leitfähige Schicht (330) aus einem Gemisch aus leitfähigen Partikeln (331) und einem Isoliermaterial hergestellt ist,
wobei die leitfähige Elektrode (352, 356) einen vorspringenden Abschnitt (430) aufweist, der in Richtung der Verdrahtungselektrode (320, 340) vorspringt,
wobei die leitfähige Elektrode (352, 356) umfasst:
eine erste Metallschicht (410), die aus einem Metall oder einer Legierung hergestellt ist; und
eine zweite Metallschicht (420), die aus einem Metall oder einer Legierung hergestellt ist, das beziehungsweise die sich von jenem bzw. jener der ersten Metallschicht (410) unterscheidet, auf der ersten Metallschicht (410) abgeschieden ist und zwischen der ersten Metallschicht (410) und der Verdrahtungselektrode (320, 340) ausgebildet ist,
wobei die zweite Metallschicht (420) eine Dicke von weniger als 100 nm aufweist,
wobei der vorspringende Abschnitt (430) von der ersten und/oder der zweiten Metallschicht (410, 420) in Richtung der Verdrahtungselektrode (320, 340) vorspringt,
wobei die erste Metallschicht eine Korngrenze aufweist und wobei der vorspringende Abschnitt auf der Korngrenze ausgebildet ist,
wobei der vorspringende Abschnitt (430) aus einem Metall oder einer Legierung (431) hergestellt ist, das beziehungsweise die sich von den Metallen beziehungsweise Legierungen der ersten und der zweiten Metallschicht (410, 420) unterscheidet,
und wobei ein Schmelzpunkt des den vorspringenden Abschnitt (430) bildenden Metalls oder der diesen bildenden Legierung (431) niedriger ist als derjenige eines die zweite Metallschicht (420) bildenden Metalls oder einer diese bildenden Legierung.

2. Anzeigevorrichtung nach Anspruch 1, wobei das den vorspringenden Abschnitt (430) bildende Metall oder die diesen bildende Legierung (431) eines von Au, Cu, Ni, Sn, Bi, Pb oder In oder eine Legierung ist, in der zumindest eines der Metalle Au, Cu, Ni, Sn, Bi, Pb oder In gemischt ist, und
wobei das die zweite Metallschicht (420) bildende Metall oder die diese bildende Legierung eines von Ti, Cr oder Mo oder eine Legierung ist, in der zumindest eines der Metalle Ti, Cr oder Mo gemischt ist.

3. Anzeigevorrichtung nach Anspruch 1, wobei die leitfähige Elektrode (352, 356) umfasst:
einen ersten Bereich, in dem der vorspringende Abschnitt (430) auf der Korngrenze (411') ausgebildet ist;
einen zweiten Bereich, in dem das die zweite Metallschicht (420) bildende Metall oder die diese bildende Legierung und der vorspringende Abschnitt (430) nacheinander auf der Korngrenze (411") abgeschieden sind; und
einen dritten Bereich, bei dem es sich um einen verbleibenden Bereich unter Ausschluss der Korngrenze (411) handelt.

4. Anzeigevorrichtung nach Anspruch 3, wobei der zweite Bereich derart ausgebildet ist, dass er eine geringere Höhe als der vorspringende Abschnitt (430) aufweist.

5. Verfahren zum Herstellen einer Anzeigevorrichtung durch Übertragen einer Mehrzahl von lichtemittierenden Halbleiterelementen (150; 250; 350) auf ein Substrat (110; 210; 310), auf dem eine Verdrahtungselektrode (320, 340) ausgebildet ist, wobei das Verfahren umfasst:
Ausbilden einer leitfähigen Elektrode (352, 356) auf einer Oberfläche jedes der Mehrzahl von lichtemittierenden Halbleiterelementen (150; 250; 350), die auf einem Übertragungssubstrat (W) angeordnet sind;
Ausbilden einer anisotropen leitfähigen Schicht (330) zwischen der leitfähigen Elektrode (352, 356) und der Verdrahtungselektrode (320, 340),
wobei die anisotrope leitfähige Schicht (330) aus einem Gemisch aus leitfähigen Partikeln (331) und einem Isoliermaterial hergestellt ist;
Ausrichten des Substrats (110; 210; 310), auf dem die Verdrahtungselektrode (320, 340) ausgebildet ist, zu dem Übertragungssubstrat (W);
Pressen des Substrats (110; 210; 310) auf das Übertragungssubstrat (W); und
Entfernen des Übertragungssubstrats (W),
wobei das Ausbilden einer leitfähigen Elektrode (352, 356) auf einer Oberfläche jedes der Mehrzahl von lichtemittierenden Halbleiterelementen (150; 250; 350) umfasst:
Abscheiden einer ersten Metallschicht (410) auf einer Oberfläche des lichtemittierenden Halbleiterelements (150; 250; 350);
Abscheiden einer zweiten Metallschicht (420) auf der ersten Metallschicht (410) derart, dass sie eine Dicke von weniger als 100 nm aufweist; und
Abscheiden eines Metalls oder einer Legierung (431), um einen vorspringenden Abschnitt (430) auf zumindest einer der ersten und der zweiten Metallschicht (410, 420) zu erzeugen,
wobei ein Schmelzpunkt eines den vorspringenden Abschnitt (430) bildenden Metalls oder einer diesen bildenden Legierung (431) niedriger ist als der eines die zweite Metallschicht (410, 420) bildenden Metalls oder einer diese bildenden Legierung.

## Revendications

1. Dispositif d'affichage comprenant :
un substrat (110 ; 210 ; 310) ;
une électrode de câblage (320) disposée sur le substrat (110 ; 210 ; 310) ;
une pluralité d'éléments électroluminescents à semi-conducteur (150 ; 250 ; 350) comportant une électrode conductrice (352, 356) électriquement connectée à l'électrode de câblage (320, 340) ; et
une couche conductrice anisotrope (330) disposée entre l'électrode conductrice (352, 356) et l'électrode de câblage (320, 340), la couche conductrice anisotrope (330) étant constituée d'un mélange de particules conductrices (331) et d'un matériau isolant,
dans lequel l'électrode conductrice (352, 356) comporte une partie saillante (430) faisant saillie en direction de l'électrode de câblage (320, 340),
dans lequel l'électrode conductrice (352, 356) comprend :
une première couche métallique (410) constituée d'un métal ou d'un alliage ; et
une deuxième couche métallique (420) constituée d'un métal ou d'un alliage différent de celui de la première couche métallique (410), déposée sur la première couche métallique (410) et formée entre la première couche métallique (410) et l'électrode de câblage (320, 340),
dans lequel la deuxième couche métallique (420) présente une épaisseur inférieure à 100 nm,
dans lequel la partie saillante (430) fait saillie à partir d'au moins l'une des première et deuxième couches métalliques (410, 420) en direction de l'électrode de câblage (320, 340),
dans lequel la première couche métallique présente un joint de grain, et dans lequel la partie saillante est formée sur le joint de grain,
la partie saillante (430) étant constituée d'un métal ou d'un alliage (431) différent de ceux des première et deuxième couches métalliques (410, 420),
et un point de fusion du métal ou de l'alliage (431) constituant la partie saillante (430) étant inférieur à celui d'un métal ou d'un alliage constituant la deuxième couche métallique (420).

2. Dispositif d'affichage selon la revendication 1, dans lequel le métal ou l'alliage (431) constituant la partie saillante (430) est l'un quelconque parmi Au, Cu, Ni, Sn, Bi, Pb ou In, ou un alliage dans lequel au moins l'un des métaux Au, Cu, Ni, Sn, Bi, Pb ou In est mélangé, et
dans lequel le métal ou l'alliage constituant la deuxième couche métallique (420) est l'un quelconque parmi Ti, Cr ou Mo, ou un alliage dans lequel au moins l'un des métaux Ti, Cr ou Mo est mélangé.

3. Dispositif d'affichage selon la revendication 1, dans lequel l'électrode conductrice (352, 356) comprend :
une première région dans laquelle la partie saillante (430) est formée sur le joint de grain (411') ;
une deuxième région dans laquelle le métal ou l'alliage constituant la deuxième couche métallique (420) et la partie saillante (430) sont déposés successivement sur le joint de grain (411") ; et
une troisième région qui est une région restante à l'exclusion du joint de grain (411).

4. Dispositif d'affichage selon la revendication 3, dans lequel la deuxième région est formée de manière à présenter une hauteur inférieure à celle de la partie saillante (430).

5. Procédé de fabrication d'un dispositif d'affichage par transfert d'une pluralité d'éléments électroluminescents à semi-conducteur (150 ; 250 ; 350) sur un substrat (110 ; 210 ; 310) sur lequel une électrode de câblage (320, 340) est formée, le procédé comprenant :
la formation d'une électrode conductrice (352, 356) sur une surface de chacun des éléments de la pluralité d'éléments électroluminescents à semi-conducteur (150 ; 250 ; 350) disposés sur un substrat de transfert (W) ;
la formation d'une couche conductrice anisotrope (330) entre l'électrode conductrice (352, 356) et l'électrode de câblage (320, 340),
dans lequel la couche conductrice anisotrope (330) est constituée d'un mélange de particules conductrices (331) et d'un matériau isolant ;
l'alignement du substrat (110 ; 210 ; 310), sur lequel l'électrode de câblage (320, 340) est formée, avec le substrat de transfert (W) ;
le pressage du substrat (110 ; 210 ; 310) contre le substrat de transfert (W) ; et
le retrait du substrat de transfert (W),
dans lequel la formation d'une électrode conductrice (352, 356) sur une surface de chacun des éléments de la pluralité d'éléments électroluminescents à semi-conducteur (150 ; 250 ; 350) comprend :
le dépôt d'une première couche métallique (410) sur une surface de l'élément électroluminescent à semi-conducteur (150 ; 250 ; 350) ;
le dépôt d'une deuxième couche métallique (420) sur la première couche métallique (410) de manière à présenter une épaisseur inférieure à 100 nm ; et
le dépôt d'un métal ou d'un alliage (431) afin de produire une partie saillante (430) sur au moins l'une des première et deuxième couches métalliques (410, 420),
dans lequel un point de fusion d'un métal ou d'un alliage (431) constituant la partie saillante (430) est inférieur à celui d'un métal ou d'un alliage constituant la deuxième couche métallique (410, 420).
